# DEMANDE DE BREVET EUROPEEN

(11) **EP 3 293 866 A1**
(43) Date de publication de la demande: **14.03.2018**
(21) Numéro de dépôt: 17190194.5
(22) Date de dépôt: 08.09.2017
(51) Int. Cl.: H02K 5/22, F04D 17/10, H05K 1/02, H05K 1/11, H02K 11/33

(54) **COMPRESSEUR DE SURALIMENTATION ELECTRIQUE**

(30) Priorité: 09.09.2016 FR 1658409
(71) Demandeur: Valeo Systemes de Controle Moteur, 95800 Cergy Saint Christophe (FR)
(72) Inventeur: SOHIER, Yannick, 95800 CERGY SAINT CHRISTOPHE (FR); LUCY, Anthony, 95800 CERGY SAINT CHRISTOPHE (FR)
(74) Mandataire: Cardon, Nicolas

(57) **Abrégé**

L'invention concerne un compresseur de suralimentation électrique (1) comprenant :
- une roue de compression des gaz (3) ;
- une machine électrique tournante (5) configurée pour entrainer la roue de compression des gaz (3) ;
- un module électronique de puissance (201) comportant :
- au moins un interrupteur électronique configuré pour recevoir et commander une énergie alimentant la machine électrique (5) ;
- un substrat plan comprenant au moins une trace de puissance surmoulée au moins en partie de matière isolante électriquement ;
ledit interrupteur électronique étant monté sur une première face dudit substrat plan de manière à être connecté électriquement à la au moins une trace de puissance.

## Description

L'invention a pour objet un compresseur de suralimentation électrique.

Dans le cadre de l'invention, un compresseur de suralimentation électrique est un dispositif utilisé pour suralimenter un moteur thermique, et fonctionnant avec une machine électrique. Plus précisément, le compresseur comporte une roue de compression entrainée par la machine électrique.

Typiquement, un compresseur de suralimentation électrique est placé sur la ligne d'admission d'air d'un moteur à combustion interne, notamment d'un véhicule, en complément d'un turbocompresseur. Le compresseur de suralimentation électrique joue le même rôle que le turbocompresseur, à savoir augmenter la pression d'admission des gaz frais dans le moteur à combustion interne, mais est utilisé notamment lors des phases transitoires pour palier aux problèmes de temps de réponse du turbocompresseur.

Un convertisseur de tension permet de commander l'énergie alimentant la machine électrique du compresseur. Il est connu d'intégrer ce convertisseur de tension dans le compresseur avec la machine électrique. Par exemple, la publication EP 2 913 909 A1 de demande de brevet européen décrit un tel compresseur de suralimentation électrique dans lequel les composants de puissance recevant et commandant une énergie alimentant la machine électrique sont montés sur une carte électronique. Cependant, il peut être complexe de réaliser une dissipation thermique des composants de puissance par la carte électronique. En outre, pour améliorer l'intégration du compresseur dans le véhicule, notamment avec le moteur à combustion interne, il est nécessaire de maitriser son encombrement et de faciliter son assemblage.

Il est donc recherché un compresseur de suralimentation électrique dans lequel le convertisseur de tension a une dissipation thermique améliorée et qui présente un agencement de ses composants facilitant son assemblage.

A cet effet, il est proposé un compresseur de suralimentation électrique comprenant :
- une roue de compression des gaz ;
- une machine électrique tournante configurée pour entrainer la roue de compression des gaz ;
- un module électronique de puissance comportant :
   - au moins un interrupteur électronique configuré pour recevoir et commander une énergie alimentant la machine électrique ;
   - un substrat plan comprenant au moins une trace de puissance surmoulée au moins en partie de matière isolante électriquement ;
ledit interrupteur électronique étant monté sur une première face dudit substrat plan de manière à être connecté électriquement à la au moins une trace de puissance.

Notamment, la trace de puissance est destinée à réaliser une liaison électrique avec un réseau électrique à partir duquel l'alimentation électrique est effectuée, ou avec une phase de la machine électrique.

Dans le compresseur de suralimentation électrique selon l'invention, la trace de puissance est intégrée dans le support du module électronique de puissance, ce qui permet d'éviter de le rapporter ultérieurement. En outre, la matière isolante électriquement peut prendre une forme désirée lors du surmoulage de la trace de puissance, en particulier une forme qui est adaptée à l'espace disponible dans le compresseur de suralimentation électrique. Cela est plus difficile à obtenir avec un compresseur comprenant une carte électronique comme dans l'art antérieur.

Selon un mode de réalisation, la première face du substrat plan est intégralement plane.

Selon un mode de réalisation, le substrat plan du module électronique de puissance comporte une deuxième face opposée à la première face, les deux faces étant parallèles entre elles, la trace de puissance et la matière isolante électriquement s'étendant respectivement sur toute l'épaisseur du substrat plan.

Selon un mode de réalisation, l'interrupteur électronique est monté sur la trace de puissance.

Selon un mode de réalisation, les bords du substrat plan du module électronique de puissance s'étendent au moins en partie suivant une ligne courbe respective.

Selon une variante, un premier bord du substrat plan s'étend selon une première ligne courbe et un deuxième bord du substrat plan s'étend suivant une deuxième ligne courbe, le premier et le deuxième bord étant des bords opposés se trouvant dans un secteur angulaire plat ou droit dont le sommet est centré sur l'axe de l'arbre de la machine électrique (5).

Selon une variante, le substrat plan du module électronique de puissance a une forme ellipsoïdale.

Selon une variante, le substrat plan du module électronique de puissance comprend au moins un bord s'étendant suivant un arc de cercle, en particulier un arc de cercle centré sur l'axe de l'arbre de la machine électrique.

Selon une variante, le substrat plan du module électronique de puissance comprend des bords opposés qui s'étendent suivant un arc de cercle respectif centré sur l'arbre de la machine électrique.

Selon un mode de réalisation, le module électronique de puissance est positionné à une position le long de l'arbre de la machine électrique, à laquelle se trouve le stator ou le rotor de la machine électrique, le module électronique de puissance étant radialement extérieur à la machine électrique.

Selon un mode de réalisation, le module électronique de puissance se trouve dans une zone qui est étanche par rapport à la machine électrique.

L'invention sera mieux comprise en faisant référence aux dessins, dans lesquels :
- les figures 1 et 2 illustrent un exemple de compresseur de suralimentation électrique selon un mode de réalisation ;
- les figures 3, 4 et 5 illustrent des exemples de module électronique de puissance utilisables dans le compresseur de suralimentation illustré en figures 1 et 2 ;
- les figures 6 et 7 illustrent des configurations pour une connexion électrique d'un module électronique de puissance.

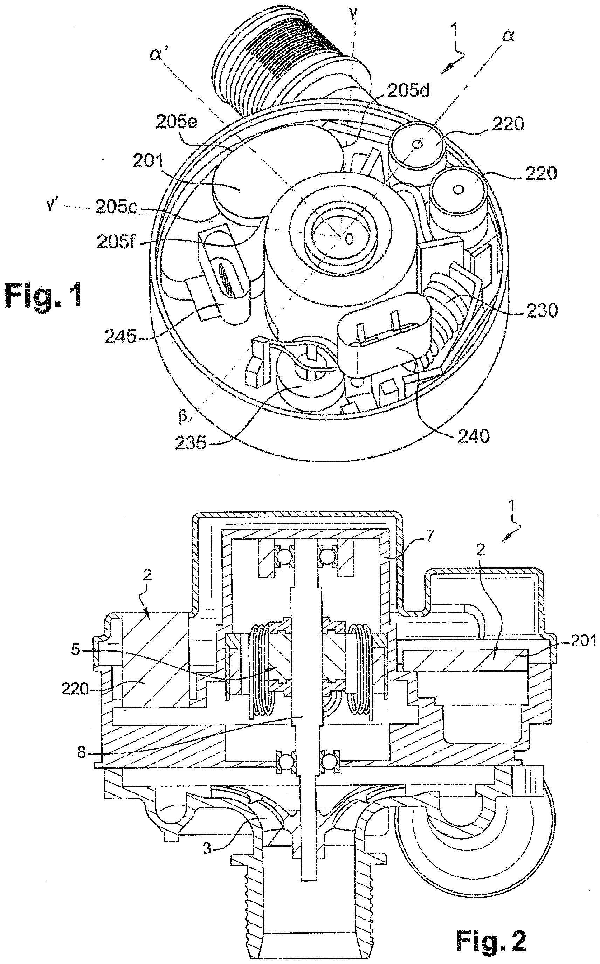

Les figures 1 et 2 présentent un exemple de compresseur de suralimentation électrique 1 selon un mode de réalisation. La figure 2 est une vue de coupe du compresseur illustré en figure 1 suivant la ligne αα'.

Le compresseur de suralimentation 1 comprend une roue de compression 3 destinée à comprimer l'air d'admission d'un moteur à combustion en association duquel le compresseur de suralimentation 1 est monté. La roue de compression 3 est entrainée en rotation par une machine électrique tournante 5. Un convertisseur de tension 2 alimente la machine électrique 5 à partir d'un réseau électrique. Notamment, le compresseur de suralimentation 1 est configuré pour être embarqué dans un véhicule pour comprimer les gaz d'admission du moteur à combustion du véhicule. En particulier, le réseau électrique est un réseau électrique du véhicule et comprend une batterie alimentant ledit réseau.

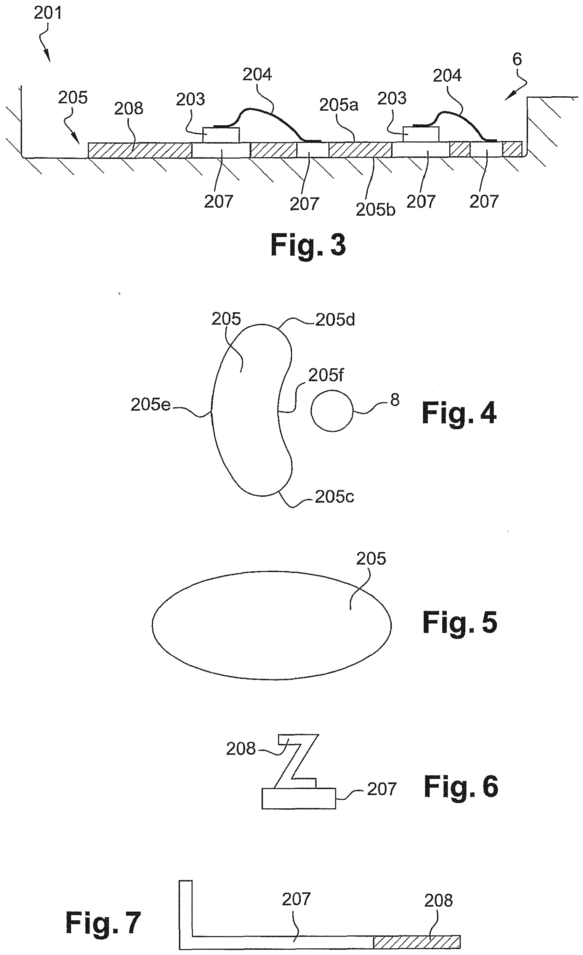

Un module électronique de puissance 201 peut faire parti du convertisseur de tension 2. Un exemple de module électronique de puissance pouvant être utilisé dans le compresseur de suralimentation électrique 1 est illustré en figure 3. Le module électronique de puissance 201 comprend des interrupteurs électroniques 203, notamment des interrupteurs semi-conducteurs, par exemple des transistors IGBT ou MOSFET. Les interrupteurs électroniques 203 sont configurés pour recevoir et commander une énergie alimentant la machine électrique 5. Notamment, les interrupteurs électroniques 203 sont des puces semi-conductrices. En particulier, les interrupteurs électroniques 203 sont des puces nues, qui peuvent être montées sur le substrat en étant dépourvu de boitier les encapsulant.

Les interrupteurs électroniques 203 sont montés sur un substrat plan 205 qui comprend des traces de puissance 207 surmoulées de matière isolante électriquement 208. Les interrupteurs électroniques 203 sont montés sur une première face 205a du substrat plan 205 de manière à être connectés électriquement à une trace de puissance 207. En particulier, les traces de puissance 207 sont destinées à réaliser une liaison électrique avec le réseau électrique à partir duquel l'alimentation électrique est effectuée, ou avec une phase de la machine électrique 5. Ce substrat plan 205 a notamment une fonction de dissipation thermique pour les interrupteurs électroniques 203.

Le substrat plan 205 s'étend donc principalement suivant un plan pour former un support pour les interrupteurs électroniques 203. Les traces de puissance 207 sont intégrées directement dans le substrat 205, ce qui facilite le montage du module de puissance 201 dans le compresseur de suralimentation 1. En outre, lors du surmoulage de la matière 208 sur les traces de puissance 207, la matière 208 peut prendre une forme adaptée à son emplacement dans le compresseur de suralimentation 1. Ainsi, la périphérie du substrat plan 205 peut avoir un tracé qui permet de minimiser l'encombrement du module de puissance 201 dans le compresseur de suralimentation 1.

Notamment, le substrat plan 205 comporte une deuxième face 205b opposée à la première face 205a et qui est parallèle à la première face 205a. Les traces de puissance 207 et la matière isolante 208 s'étendent respectivement sur toute l'épaisseur du substrat plan 205, c'est-à-dire depuis la première face 205a jusqu'à la deuxième face 205b. La première face 205a comprend donc au moins en partie une première face de la trace de puissance 207, et la deuxième face 205b comprend au moins en partie une deuxième face de la trace de puissance 207. Ainsi, les traces de puissance 207 peuvent venir en appui contre un support formant dissipateur thermique, ce qui améliore l'évacuation de chaleur par la trace de puissance 207. Une couche d'isolant électrique, permettant cependant une diffusion thermique vers le support, peut être prévue entre le substrat plan 205 et le support.

En particulier, les interrupteurs électroniques 203 sont montés sur des traces de puissance 207. La trace de puissance 207 permet alors d'évacuer une chaleur produite par l'interrupteur électronique 203, par exemple comme expliqué ci-dessus. En particulier, la trace de puissance 207 sur laquelle est montée l'interrupteur électronique 203 correspond à une trace de puissance 207 à laquelle l'interrupteur électronique 203 est liée électriquement. Autrement dit, l'interrupteur électronique 203 peut échanger un courant électrique avec la trace de puissance 207 sur laquelle il est monté.

Les interrupteurs électroniques 203 peuvent être liés électriquement à une trace de puissance 207 qui est différente de celle sur laquelle ils ont montés. Par exemple, l'interrupteur électronique 203 et la trace de puissance 207 peuvent être liés par un fil conducteur 204 ayant une extrémité connectée à l'interrupteur électronique 203 et l'autre extrémité connectée à la trace de puissance 207. Un tel fil conducteur 204 peut être mis en place par une technique de câblage par fil (ou « wire bonding » en anglais).

Les traces de puissance 207 sont par exemple en forme de lame en matière électriquement conductrice, notamment métallique.

La première face 205a du substrat plan 205 peut être intégralement plane. Autrement dit, le substrat plan 205 peut être dépourvu de parois latérales s'étendant depuis sa première face 205a. Ceci est particulièrement le cas lorsque le module de puissance 201 est monté dans une zone du compresseur de suralimentation 1 qui est étanche par rapport à la machine électrique 5 et/ou par rapport à d'autres composants du compresseur de suralimentation 1. Il n'est alors pas nécessaire de prévoir dans le module de puissance 201 une cavité qui recevrait les interrupteurs électroniques 203 pour ensuite être remplie d'un matériau protecteur tel qu'une résine ou un gel. Une telle cavité aurait par exemple été formée par une ou des excroissances s'étendant transversalement depuis la première face 205a du substrat plan 205. La zone étanche peut être formée par une cavité 6 dans le compresseur 1 qui est remplie par une résine ou un gel protecteur, le fond de la cavité 6 formant un support pour le module de puissance 1, par exemple tel qu'illustré en figure 3. La zone étanche peut aussi être obtenue par une paroi 7 la séparant d'une zone du compresseur comprenant la machine électrique 5 et/ou les autres composants du compresseur de suralimentation 1. Une telle paroi 7 peut être rendue étanche en prévoyant un joint d'étanchéité sur ses bords.

En particulier, les deux faces 205a, 205b du substrat plan 205 sont intégralement planes, ce qui limite son encombrement et facilite son intégration dans le compresseur de suralimentation 1.

Pour diminuer l'encombrement du module de puissance 201, les bords du substrat plan 205 peuvent s'étendre au moins en partie suivant une ligne courbe respective.

Par exemple, en figure 1, un premier bord 205c du substrat plan 205 s'étend suivant une première ligne courbe et un deuxième bord 205d du substrat plan 205 s'étend suivant une deuxième ligne courbe. Notamment, les deux lignes courbes sont dépourvues de portion droite. En particulier, les deux lignes courbes sont des arcs de cercle tournés vers l'intérieur du substrat plan 205. Les deux bords opposés 205c, 205d peuvent être reliés par des bords 205e, 205f opposés qui sont droits ou courbes.

Dans l'exemple décrit ici, les deux bords 205c et 205d se trouvent localisés dans un même secteur angulaire plat dont le sommet O est centré sur l'arbre 8 de la machine électrique 5 et qui est défini par les deux axes α et β.

Dans l'exemple décrit ici, les deux bords 205c et 205d se trouvent également localisés dans un même secteur angulaire droit dont le sommet O est centré sur l'arbre 8 de la machine électrique 5 et qui est défini par les deux axes γ et γ'.

Le substrat plan 205 peut comprendre au moins un bord s'étendant suivant un arc de cercle centré sur l'axe de l'arbre 8 de la machine électrique 5. Par exemple, comme illustré en figure 4, le substrat plan 205 du module électronique de puissance peut comprendre des bords 205e, 205f opposés qui s'étendent suivant un arc de cercle respectif centré sur l'axe de l'arbre 8 de la machine électrique 5.

Le substrat plan 205 peut avoir une forme ellipsoïdale comme illustré par exemple en figure 5.

Ces formes du substrat plan 205, en particulier la forme illustrée en figure 4, permettent un agencement du module de puissance 201 dans le compresseur de suralimentation 1 avec un encombrement limité. C'est notamment le cas dans une variante, par exemple illustrée en figures 1 et 2, dans laquelle le module de puissance 201 est positionné à une position le long de l'arbre 8 de la machine électrique 5, à laquelle se trouve le stator ou le rotor de la machine électrique 5. Ainsi, le module de puissance 201 se trouve radialement à l'extérieur de la machine électrique 5. Par conséquent, le module de puissance 201 n'est pas traversé par l'arbre 8 de la machine électrique 5. En particulier, d'autres éléments du convertisseur 2, tels que des condensateurs 220, des inductances 230, 235, un connecteur de puissance 240 ou un connecteur de signal 245, sont positionnés autour de la machine électrique 5 comme le module de puissance 201.

Afin d'assurer une connexion électrique entre les traces de puissance 207 et un réseau électrique à partir duquel l'alimentation électrique est effectuée, ou avec une phase de la machine électrique 5, le module puissance 201 peut comprendre des connecteurs montés, notamment soudés, sur la première face de la trace de puissance 207. En particulier, ces connecteurs 208 sont formés d'une lame conductrice électriquement, pliée en forme de Z, par exemple comme illustré en figure 6. Certaines traces de puissance 207 peuvent comprendre une extrémité repliée, par exemple comme illustré en figure 7 pour assurer la connexion électrique.

Bien entendu, l'invention n'est nullement limitée aux exemples décrits et illustrés.

## Revendications

1. Compresseur de suralimentation électrique (1) comprenant :
- une roue de compression des gaz (3) ;
- une machine électrique tournante (5) configurée pour entrainer la roue de compression des gaz (3) ;
- un module électronique de puissance (201) comportant :
- au moins un interrupteur électronique (203) configuré pour recevoir et commander une énergie alimentant la machine électrique (5) ;
- un substrat plan (205) comprenant au moins une trace de puissance (207) surmoulée au moins en partie de matière isolante électriquement (208) ;
ledit interrupteur électronique (203) étant monté sur une première face (205a) dudit substrat plan (205) de manière à être connecté électriquement à la au moins une trace de puissance (207).

2. Compresseur de suralimentation électrique (1) selon la revendication 1, dans lequel la première face (205a) du substrat plan (205) est intégralement plane.

3. Compresseur de suralimentation électrique (1) selon la revendication 1 ou 2, dans lequel le substrat plan (205) du module électronique de puissance (201) comporte une deuxième face (205b) opposée à la première face (205a), les deux faces étant parallèles entre elles, la trace de puissance (207) et la matière isolante électriquement (208) s'étendant respectivement sur toute l'épaisseur du substrat plan (205).

4. Compresseur de suralimentation électrique (1) selon l'une des revendications précédentes, dans lequel l'interrupteur électronique (203) est monté sur la trace de puissance (207).

5. Compresseur de suralimentation électrique (1) selon l'une des revendications précédentes, dans lequel les bords (205c, 205d, 205e, 205f) du substrat plan (205) du module électronique de puissance (201) s'étendent au moins en partie suivant une ligne courbe respective.

6. Compresseur de suralimentation électrique (1) selon l'une des revendications 1 à 5, dans lequel un premier bord (205c) du substrat plan (205) s'étend selon une première ligne courbe et un deuxième bord (205d) du substrat plan (205) s'étend suivant une deuxième ligne courbe, le premier et le deuxième bord étant des bords opposés se trouvant dans un secteur angulaire plat ou droit dont le sommet est centré sur l'axe de l'arbre de la machine électrique (5).

7. Compresseur de suralimentation électrique (1) selon la revendication 5 ou 6, dans lequel le substrat plan (205) du module électronique de puissance (201) a une forme ellipsoïdale.

8. Compresseur de suralimentation électrique (1) selon la revendication 5 ou 6, dans lequel le substrat plan (205) du module électronique de puissance (201) comprend au moins un bord (205e, 205f) s'étendant suivant un arc de cercle, en particulier un arc de cercle centré sur l'axe de l'arbre de la machine électrique (5).

9. Compresseur de suralimentation électrique (1) selon la revendication précédente, dans lequel le substrat plan (205) du module électronique de puissance (201) comprend des bords opposés (205e, 205f) qui s'étendent suivant un arc de cercle respectif centré sur l'arbre (8) de la machine électrique (5).

10. Compresseur de suralimentation électrique (1) selon l'une des revendications précédentes, dans lequel le module électronique de puissance (201) est positionné à une position le long de l'arbre (8) de la machine électrique (5), à laquelle se trouve le stator ou le rotor de la machine électrique (5), le module électronique de puissance (201) étant radialement extérieur à la machine électrique (5).

11. Compresseur de suralimentation électrique (1) selon l'une des revendications précédentes, dans lequel le module électronique de puissance (201) se trouve dans une zone qui est étanche par rapport à la machine électrique (5).
